# EUROPÄISCHE PATENTSCHRIFT

(11) **EP 3 081 001 B1**
(45) Veröffentlichungstag und Bekanntmachung des Hinweises auf die Patenterteilung: **20.02.2019**
(21) Anmeldenummer: 14845030.7
(22) Anmeldetag: 05.12.2014
(51) Int. Cl.: H04Q 9/00, G01R 31/36, H01M 10/48, H01M 10/42, H01M 10/633

(54) **VERFAHREN ZUM ÜBERTRAGEN EINES MINIMALEN UND/ODER EINES MAXIMALEN WERTES EINES BATTERIESYSTEMPARAMETERS UND BATTERIESYSTEM ZUR AUSFÜHRUNG EINES SOLCHEN VERFAHRENS**
METHOD FOR TRANSFERRING A MINIMUM AND/OR A MAXIMUM VALUE OF A BATTERY SYSTEM PARAMETER AND BATTERY SYSTEM FOR CARRYING OUT SUCH A METHOD
PROCÉDÉ POUR TRANSMETTRE UNE VALEUR MINIMALE ET/OU UNE VALEUR MAXIMALE D'UN PARAMÈTRE DE SYSTÈME DE BATTERIE ET SYSTÈME DE BATTERIE POUR METTRE EN OEUVRE UN TEL PROCÉDÉ

(30) Priorität: 09.12.2013 DE 102013225243
(43) Veröffentlichungstag der Anmeldung: 19.10.2016
(73) Patentinhaber: Robert Bosch GmbH, 70442 Stuttgart (DE); Samsung SDI Co., Ltd., Yongin-si, Gyeonggi-do 446-577 (KR)
(72) Erfinder: BUTZMANN, Stefan, 58579 Schalksmühle (DE)
(74) Vertreter: Bee, Joachim
(86) Internationale Anmeldenummer: PCT/EP2014/076667
(87) Internationale Veröffentlichungsnummer: WO 2015/086442

(56) Entgegenhaltungen:
- EP-A2- 2 428 809
- DE-A1-102012 104 790
- US-A1- 2010 194 345

## Beschreibung

Die Erfindung betrifft ein Verfahren zum Übertragen eines minimalen und/oder eines maximalen Wertes eines Batteriesystemparameters aus einer Menge von Werten dieses Batteriesystemparameters in einem eine Mehrzahl von Batteriezellen umfassenden Batteriesystem, wobei der minimale Wert des Batteriesystemparameters über eine erste Datenleitung übertragen wird und/oder der maximale Wert des Batteriesystemparameters über eine zweite Datenleitung übertragen wird.

Ferner betrifft die Erfindung ein Batteriesystem mit einer Mehrzahl von Batteriezellen und einem Batteriemanagementsystem.

### Stand der Technik

Batteriesysteme mit einer Mehrzahl von elektrisch miteinander verschalteten Batteriezellen, insbesondere mit einer Mehrzahl von elektrisch miteinander verschalteten nachladbaren Lithium-Ionen-Zellen, werden insbesondere in Hybrid-, Plug-In-Hybrid- oder Elektrofahrzeugen zur Bereitstellung der erforderlichen elektrischen Energie eingesetzt. Üblicherweise umfasst ein Batteriesystem darüber hinaus ein Batteriemanagementsystem zur Überwachung und Regelung der Batteriezellen des Batteriesystems beziehungsweise zur Überwachung und Regelung einer Mehrzahl von elektrisch miteinander verschalteten Batteriezellen des Batteriesystems, insbesondere zur Überwachung und Regelung eines oder mehrerer Batteriemodule des Batteriesystems. Ein solches Batteriemanagementsystem umfasst üblicherweise wenigstens eine Steuergeräteeinheit und Zellüberwachungseinheiten, insbesondere sogenannten Cell Supervision Circuits (CSC). Das Batteriemanagementsystem des Batteriesystems ist insbesondere dafür zuständig, dass bestimmte Batteriesystemparameter beim Betrieb des Batteriesystems vordefinierte Grenzwerte nicht überschreiten beziehungsweise nicht unterschreiten. So ist insbesondere durch das Batteriemanagementsystem sicherzustellen, dass beispielsweise Batteriezelltemperaturen oder Batteriezellspannungen als Batteriesystemparameter stets innerhalb vordefinierter Grenzen bleiben.

Zur Überwachung und Regelung der Batteriesystemparameter weisen Batteriesysteme Einheiten zur Erfassung und Digitalisierung von Batteriesystemparametern auf. Aus der Druckschrift DE 10 2010 063 258 A1 ist als Einheit zur Erfassung eines Batteriesystemparameters beispielsweise eine Vorrichtung zum Messen einer Zellspannung einer Batterie bekannt. Weitere Vorrichtungen zur Überwachung und/oder Erfassung von Batteriesystemparametern sind darüber hinaus beispielsweise aus den Druckschriften DE 600 03 581 T2, JP 2001 0251 73 A, DE 37 02 591 C2 und DE 10 2012 104 790 A1 bekannt.

Da die Batteriesystemparameter, wie bereits ausgeführt, bestimmte Grenzwerte nicht überschreiten beziehungsweise nicht unterschreiten sollen, sind minimale und/oder maximale Batteriesystemparameter eines Batteriesystems von besonderer Relevanz. Damit diese minimalen und/oder maximalen Batteriesystemparameter bei der Überwachung und Regelung des Batteriesystems genutzt werden können, müssen diese innerhalb des Batteriesystems übertragen werden, insbesondere von den Einheiten zur Erfassung wenigstens eines Batteriesystemparameters an eine zentrale Steuergeräteeinheit des Batteriesystems. Hierzu ist insbesondere bekannt, erfasste Batteriesystemparameter analog, beispielsweise unter Nutzung des Daisy-Chain-Prinzips, zu übertragen.

Nachteilig bei einer solchen analogen Übertragung ist, dass diese anfällig gegen elektromagnetische Störungen ist und daher weniger zuverlässig.

Vor diesem Hintergrund ist es eine Aufgabe der Erfindung die Übertragung eines minimalen und/oder maximalen Wertes eines Batteriesystemparameters aus einer Mehrzahl erfasster Werte dieses Batteriesystemparameters in einem Batteriesystem zu verbessern, insbesondere dahingehend, dass die Übertragung wenig störanfällig ist und vorteilhafterweise robust gegen elektromagnetische Störungen.

### Offenbarung der Erfindung

Zur Lösung der Aufgabe wird ein Verfahren zum Übertragen eines minimalen und/oder eines maximalen Wertes eines Batteriesystemparameters aus einer Menge von Werten dieses Batteriesystemparameters in einem eine Mehrzahl von Batteriezellen umfassenden Batteriesystem vorgeschlagen, wobei der minimale Wert des Batteriesystemparameters über eine erste Datenleitung übertragen wird und/oder der maximale Wert des Batteriesystemparameters über eine zweite Datenleitung übertragen wird. Erfindungsgemäß wird dabei ein periodisches Taktsignal mit einer festen Periodendauer erzeugt. Zur Übertragung des minimalen Wertes des Batteriesystemparameters wird zudem für jeden Wert des Batteriesystemparameters phasensynchron zu dem Taktsignal ein erstes Signal, welches entweder einen ersten Signalzustand oder einen zweiten Signalzustand annehmen kann, erzeugt und auf die erste Datenleitung gegeben, wobei ein minimaler Batteriesystemparameter auf der ersten Datenleitung durch einen Übergang von dem ersten Signalzustand zu dem zweiten Signalzustand dargestellt wird und der minimale Wert des Batteriesystemparameters durch die zeitliche Dauer, die der zweite Signalzustand gehalten wird, bezogen auf die Periodendauer des Taktsignals repräsentiert wird, und/oder zur Übertragung des maximalen Wertes des Batteriesystemparameters wird für jeden Wert des Batteriesystemparameters phasensynchron zu dem Taktsignal ein zweites Signal, welches entweder einen ersten Signalzustand oder einen zweiten Signalzustand annehmen kann, erzeugt und auf die zweite Datenleitung gegeben, wobei ein maximaler Batteriesystemparameter auf der zweiten Datenleitung durch einen Übergang von dem zweiten Signalzustand zu dem ersten Signalzustand dargestellt wird und der maximale Wert des Batteriesystemparameters durch die zeitliche Dauer, die der erste Signalzustand gehalten wird, bezogen auf die Periodendauer des Taktsignals repräsentiert wird.

Batteriesystemparameter sind insbesondere innerhalb des Batteriesystems erfasste Messgrößen. Insbesondere sind Batteriesystemparameter elektrische Spannungen, insbesondere Batteriezellspannungen, Batteriezelltemperaturen, Batteriezellströme, Ladezustände einer Batteriezelle (SOC; SOC: State of Charge) und/oder Alterungszustände einer Batterie (SOH; SOH: State of Health).

Insbesondere ist vorgesehen, dass die Menge von Werten eines Batteriesystemparameters von Einheiten des Batteriesystems erfasst wird, insbesondere von Zellüberwachungseinheiten, vorzugsweise von sogenannten Cell Supervision Circuits (CSC). Des Weiteren ist insbesondere vorgesehen, dass minimale und/oder maximale Werte eines Batteriesystemparameters von diesen Einheiten des Batteriesystems an wenigstens eine Steuergeräteeinheit des Batteriesystems übertragen werden, vorzugsweise an eine zentrale Steuergeräteeinheit, wie insbesondere eine Battery Control Unit (BCU). Des Weiteren ist bevorzugt vorgesehen, dass die wenigstens eine Steuergeräteeinheit des Batteriesystems das periodische Taktsignal mit der festen Periodendauer erzeugt, wobei dieses Taktsignal vorteilhafterweise über eine Signalleitung jeweils an die weiteren Einheiten des Batteriesystems, insbesondere die Zellüberwachungseinheiten, übertragen wird.

Das Taktsignal ist vorzugsweise ein Rechtecksignal. Das Taktsignal wechselt dabei innerhalb einer festen Periodendauer zwischen einem ersten Signalzustand (vorzugsweise "low") und einem zweiten Signalzustand (vorzugsweise "high"). Das Taktsignal wird dabei zeitgleich an jede der Einheiten des Batteriesystems übertragen, die Werte eines Batteriesystemparameters erfassen, damit aus dieser Menge von Werten dieses Batterieparameters der minimale und/oder der maximale Wert dieses Batteriesystemparameters übertragen werden kann.

Besonders bevorzugt werden der minimale und der maximale Wert eines Batteriesystemparameters übertragen. Insbesondere ist vorgesehen, dass das erste Signal und/oder das zweite Signal zwischen den Signalzuständen "low" und "high" wechseln kann, wobei der erste Signalzustand vorzugsweise "low" ist und der zweite Signalzustand vorzugsweise "high". Die Übertragung ist dabei vorteilhafterweise als 3-Draht-Protokoll realisiert. Vorzugsweise sind das erzeugte erste Signal und/oder das erzeugte zweite Signal jeweils pulsweitenmodulierte Signale (PWM-Signale) wobei jeweils die Pulslänge der Signale bezogen auf die Periodendauer des Taktsignals den jeweiligen Wert des Batteriesystemparameters repräsentiert. Über die Wahl der Periodendauer des Taktsignals wird vorteilhafterweise der maximal wiedergebbare Wert eines Batteriesystemparameters definiert. Die Übertragung eines minimalen und/oder eines maximalen Wertes eines Batteriesystemparameters erfolgt also vorteilhafterweise binär. Hierdurch ist die Übertragung vorteilhafterweise vergleichsweise robust gegen elektromagnetische Störungen und wenig störanfällig.

Insbesondere ist als eine bevorzugte Ausgestaltung des erfindungsgemäßen Verfahrens vorgesehen, dass das für einen Wert des Batteriesystemparameters auf die erste Datenleitung gegebene erste Signal auf der ersten Datenleitung mit den zeitgleich auf die erste Datenleitung gegebenen ersten Signalen der weiteren Werte des Batteriesystemparameters logisch verknüpft wird, sodass der minimale Wert des Batteriesystemparameters über die erste Datenleitung übertragen wird, und/oder dass das für einen Wert des Batteriesystemparameters auf die zweite Datenleitung gegebene zweite Signal auf der zweiten Datenleitung mit dem zeitgleich auf die zweite Datenleitung gegebenen zweiten Signalen der weiteren Werte des Batteriesystemparameters logisch verknüpft wird, sodass der maximale Wert des Batteriesystemparameters über die zweite Datenleitung übertragen wird. Die logische Verknüpfung wird vorzugsweise jeweils durch eine UND-Verknüpfung (Verundung) realisiert. Vorzugsweise erfolgt die Verundung der ersten Signale indem die ersten Signale jeweils über einen Open-Collector-Ausgang auf die erste Datenleitung gegeben werden. Der Tastgrad des Signals auf der ersten Datenleitung, also das Verhältnis von Impulsdauer des Signals auf der ersten Datenleitung zu der Periodendauer des Taktsignals, gibt dann vorteilhafterweise den Wert des minimalen Batteriesystemparameters an. Analog hierzu wird vorzugsweise die Verundung der zweiten Signale, die auf die zweite Datenleitung gegeben werden, realisiert. Details zur logischen Verknüpfung der ersten Signale und/oder der zweiten Signale werden im Zusammenhang mit den in den Zeichnungen dargestellten Ausführungsbeispielen näher erläutert.

Gemäß einer weiteren vorteilhaften Ausgestaltung des erfindungsgemäßen Verfahrens wird als Menge von Werten des Batteriesystemparameters jeweils die minimale Spannung und/oder die maximale Spannung einer Batteriezelle eines Batteriemoduls des Batteriesystems erfasst und der minimale Wert der erfassten minimalen Spannung und/oder der maximale Wert der erfassten maximalen Spannung übertragen, wobei für jedes Batteriemodul zur Übertragung des minimalen Wertes der erfassten minimalen Spannung jeweils phasensynchron zu dem Taktsignal das erste Signal erzeugt und auf die erste Datenleitung gegeben wird und/oder für jedes Batteriemodul zur Übertragung des maximalen Wertes der erfassten maximalen Spannung jeweils phasensynchron zu dem Taktsignal das zweite Signal erzeugt und auf die zweite Datenleitung gegeben wird. Vorzugsweise weist das Batteriesystem dabei für jedes Batteriemodul wenigstens einen Mikrocontroller auf, welcher vorteilhafterweise ausgebildet ist, erfasste Batteriezellspannungen hinsichtlich eines minimalen und/oder maximalen Wertes einer erfassten Batteriezellspannung auszuwerten.

Gemäß einer besonders vorteilhaften Ausgestaltungsvariante des erfindungsgemäßen Verfahrens ist vorgesehen, dass als Menge von Werten des Batteriesystemparameter jeweils die Batteriezellspannung einer Batteriezelle des Batteriesystems erfasst wird und der minimale Werte der erfassten Batteriezellspannung und/oder der maximale Wert der erfassten Batteriezellespannung übertragen wird, wobei für jede Batteriezelle zur Übertragung des minimalen Wertes der erfassten Batteriezellspannung jeweils phasensynchron zu dem Taktsignal das erste Signal erzeugt und auf die erste Datenleitung gegeben wird und/oder für jede Batteriezelle zur Übertragung des maximalen Wertes der erfassten Batteriezellspannung jeweils phasensynchron zu dem Taktsignal das zweite Signal erzeugt und auf die zweite Datenleitung gegeben wird. Ein minimaler Wert einer Batteriezellspannung ist dabei insbesondere zu einem Erfassungszeitpunkt derjenige Wert aus einer zu dem Zeitpunkt erfassten Menge von Batteriezellspannungen, welcher die minimale Batteriezellspannung aus der Menge von erfassten Batteriezellspannungen zu diesem Zeitpunkt repräsentiert. Ein maximaler Wert einer Batteriezellspannung ist insbesondere zu einem Erfassungszeitpunkt derjenige Wert aus einer zu dem Zeitpunkt erfassten Menge von Batteriezellspannungen, welcher die maximale Batteriezellspannung aus der Menge von erfassten Batteriezellspannungen zu diesem Zeitpunkt repräsentiert.

Bei einer weiteren vorteilhaften Ausgestaltung des erfindungsgemäßen Verfahrens wird phasensynchron zu dem Taktsignal eine Sägezahnspannung erzeugt, wobei eine Spannung, deren minimaler und/oder maximaler Wert übertragen werden soll, erfasst wird und durch jeweils einen Vergleich der erfassten Spannung mit der Sägezahnspannung unter Nutzung einer Komparatoreinheit mit einem positiven Eingang und einem invertierenden Eingang das erste Signal und/oder das zweite Signal als Ausgangssignal der Komparatoreinheit erzeugt wird. Vorteilhafterweise ist bei dieser Ausgestaltung ein Mikrocontroller oder eine ähnliche Auswerteeinrichtung zur Bestimmung von minimalen und/oder maximalen Batteriesystemparametern aus einer Menge dieses Batteriesystemparameters nicht erforderlich.

Insbesondere ist bei der vorgenannten Ausgestaltung des erfindungsgemäßen Verfahrens vorgesehen, dass zur Erzeugung des ersten Signals die erfasste Spannung jeweils an den positiven Eingang der Komparatoreinheit angelegt wird und die Sägezahnspannung jeweils an den invertierenden Eingang der Komparatoreinheit angelegt wird und/oder dass zur Erzeugung des zweiten Signals die erfasste Spannung jeweils an den invertierenden Eingang der Komparatoreinheit angelegt wird und die Sägezahnspannung jeweils an den positiven Eingang der Komparatoreinheit angelegt wird.

Vorteilhafterweise wird das erste Signal über eine galvanische Trenneinrichtung auf die erste Datenleitung gegeben und/oder das zweite Signal über eine galvanische Trenneinrichtung auf die zweite Datenleitung gegeben. Vorzugsweise ist die galvanische Trenneinrichtung ein Isolator oder ein Optokoppler. Zur Erfassung und Übertragung des minimalen Wertes einer erfassten Spannung ist dabei insbesondere vorgesehen, dass eine dem Ausgang der Komparatoreinheit nachgeschaltete Isolatoreinheit ausgangsseitig auf den Signalzustand "low" gezogen wird, wenn die jeweilige erfasste Spannung die Sägezahnspannung übersteigt. Zur Erzeugung des zweiten Signals zur Übertragung des maximalen Wertes einer erfassten Spannung ist insbesondere vorgesehen, dass eine dem Ausgang der Komparatoreinheit nachgeschaltete Isolatoreinheit ausgangsseitig auf den Signalzustand "high" gezogen wird, wenn die Sägezahnspannung die betreffende erfasste Spannung übersteigt.

Eine weitere vorteilhafte Ausgestaltung des erfindungsgemäßen Verfahrens sieht vor, dass zur Erzeugung der Sägezahnspannung das Taktsignal für jede zu erzeugende Sägezahnspannung jeweils ein Schaltelement steuert, wobei das Schaltelement bei einem ersten Signalzustand des Taktsignal schließt und beim zweiten Signalzustand des Taktsignals öffnet, wobei bei geöffnetem Schaltelement ein Kondensator rampenförmig aufgeladen und bei geschlossenem Schaltelement der Kondensator entladen wird. Als Schaltelement ist bevorzugt ein MOSFET (MOSFET: Metal Oxide Semiconductor Field-Effect Transistor) vorgesehen. Vorteilhafterweise wird der den Kondensator aufladende Strom derart geregelt, dass die Spannung des Kondensators zum Zeitpunkt des Wechsels des Taktsignals von dem ersten Signalzustand zu dem zweiten Signalzustand einer vorgegebenen Referenzspannung entspricht. Hierdurch wird vorteilhafterweise erzielt, dass die Rampensteilheit in allen voneinander unabhängigen Batteriemodulen des Batteriesystems gleich ist.

Gemäß einer vorteilhaften Weiterbildung des erfindungsgemäßen Verfahrens ist vorgesehen, dass ein auf die erste Datenleitung gegebenes erstes Signal und/oder ein auf die zweite Datenleitung gegebenes zweites Signal von Einheiten des Batteriesystems, insbesondere von Zellüberwachungseinheiten des Batteriesystems, empfangen und ausgewertet werden. Die ersten Signale und/oder die zweiten Signale werden dabei vorteilhafterweise direkt von den Einheiten des Batteriesystems empfangen ohne den Umweg über eine zentrale Steuergeräteeinheit. Vorteilhafterweise sind die den Einheiten des Batteriesystems bereitgestellten ersten Signale und/oder zweiten Signale von den Einheiten zur Überwachung und/oder Regelung des Batteriesystems und/oder zur Überwachung und/oder Regelung einer Mehrzahl von Batteriezellen des Batteriesystems nutzbar. Insbesondere ist vorgesehen, dass die Einheiten, welche das erste Signal und/oder das zweite Signal empfangen, wenigstens einen Mikrocontroller umfassen, der den Datenstrom auf der ersten Datenleitung und/oder der zweiten Datenleitung auswertet. Vorzugsweise wertet der Mikrocontroller jeweils zusätzlich die Batteriezellspannungen über einen Analog-Digital-Konverter aus, um unter Berücksichtigung der Auswertungsergebnisse Batteriezellen dem Batteriesystem zuzuschalten oder Batteriezellen zu überbrücken, sodass diese quasi von dem Batteriesystem getrennt sind. Vorzugsweise wertet der Mikrocontroller bei dieser Ausgestaltungsvariante jeweils auch das periodische Taktsignal aus und/oder steuert die Datenausgänge, über welche das erste Signal auf die erste Datenleitung gegeben wird und das zweite Signal auf die zweite Datenleitung gegeben wird, über isolierte Open-Collector-Ausgänge und/oder liest die Signale auf der ersten Datenleitung und/oder der zweiten Datenleitung ein. Bei dieser Ausgestaltungsvariante kann das Erzeugen einer Sägezahnspannung entfallen.

Zur Lösung der eingangs genannten Aufgabe wird des Weiteren ein Batteriesystem mit einer Mehrzahl von Batteriezellen und einem Batteriemanagementsystem vorgeschlagen, wobei das Batteriesystem zur Ausführung eines erfindungsgemäßen Verfahrens ausgebildet ist.

Strukturelle Merkmale des erfindungsgemäßen Batteriesystems ebenso wie weitere vorteilhafte Einzelheiten, Merkmale und Ausgestaltungsdetails der Erfindung werden im Zusammenhang mit den in den Figuren dargestellten Ausführungsbeispielen näher erläutert. Dabei zeigt:
- Fig.1: in einer schematischen Darstellung einen Ausschnitt eines Ausführungsbeispiels für ein zur Ausführung eines erfindungsgemäßen Verfahrens ausgebildetes Batteriesystem;
- Fig. 2: in einer schematischen Darstellung ein Ausführungsbeispiel für ein mittels des erfindungsgemäßen Verfahrens erzeugtes erstes Signal;
- Fig. 3: in einer schematischen Darstellung ein Ausführungsbeispiel für ein mittels eines erfindungsgemäßen Verfahrens erzeugtes zweites Signal;
- Fig. 4: in einer schematischen Darstellung einen Ausschnitt eines weiteren Ausführungsbeispiels für ein zur Ausführung eines erfindungsgemäßen Verfahrens ausgebildetes Batteriesystem;
- Fig. 5: in einer schematischen Darstellung ein Ausführungsbeispiel für die Erzeugung einer zu einem Taktsignal phasensynchronen Sägezahnspannung zur Nutzung in einem erfindungsgemäßen Verfahren;
- Fig. 6: in einer schematischen Darstellung einen Ausschnitt eines weiteren Ausführungsbeispiels für ein zur Ausführung eines erfindungsgemäßen Verfahrens ausgebildetes Batteriesystem;
- Fig. 7: in einer schematischen Darstellung einen Ausschnitt eines weiteren Ausführungsbeispiels für ein zur Ausführung eines erfindungsgemäßen Verfahrens ausgebildetes Batteriesystem;
- Fig. 8: in einer schematischen Darstellung einen Ausschnitt eines weiteren Ausführungsbeispiels für ein zur Ausführung eines erfindungsgemäßen Verfahrens ausgebildetes Batteriesystem; und
- Fig. 9: in einer schematischen Darstellung ein Ausführungsbeispiel für die Erzeugung eines ersten Signals unter Nutzung einer Sägezahnspannung.

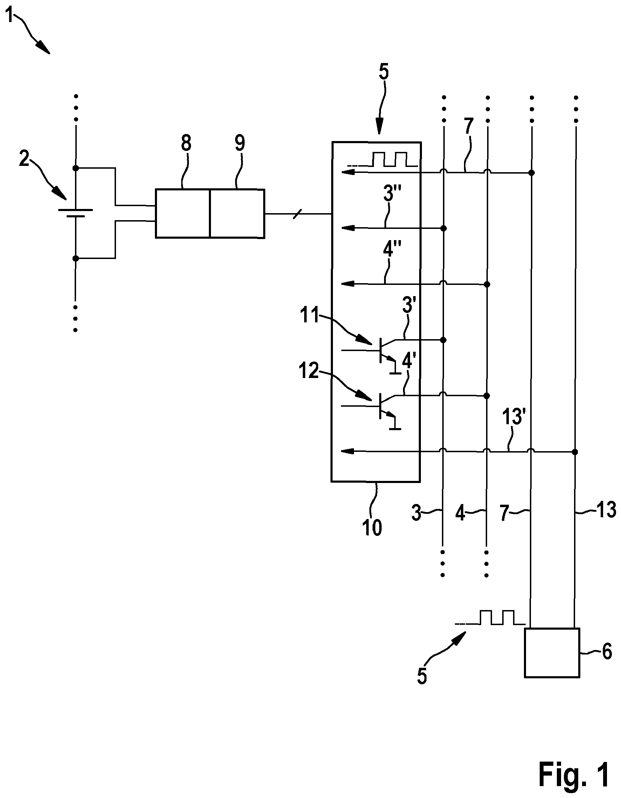

In Fig. 1 ist ein Ausschnitt eines Batteriesystems 1 dargestellt. Das Batteriesystem 1 umfasst eine Mehrzahl von Batteriezellen 2. Aus Gründen der besseren Übersichtlichkeit ist in dem in Fig. 1 gezeigten Ausführungsbeispiel nur eine Batteriezelle 2 dargestellt. Das Batteriesystem 1 umfasst eine zentrale Steuergeräteeinheit 6 als Bestandteil eines Batteriemanagementsystems des Batteriesystems 1. Die Steuergeräteeinheit 6 erzeugt ein periodisches Taktsignal 5 mit einer festen Periodendauer. Das Taktsignal 5 wird dabei auf eine Leitung 7 gegeben und einer Mehrzahl von Einheiten des Batteriesystems 1 zugeleitet. Das Batteriesystem 1 umfasst des Weiteren eine erste Datenleitung 3 zur Übertragung minimaler Werte eines Batteriesystemparameters und eine zweite Datenleitung 4 zur Übertragung maximaler Werte eines Batteriesystemparameters. Ferner umfasst das Batteriesystem 1 wenigstens eine weitere Leitung 13, über welche die zentrale Steuergeräteeinheit 6 Daten mit den weiteren Einheiten des Batteriesystems 1 austauschen kann, wobei die weiteren Einheiten jeweils über eine Signalleitung 13' mit der Leitung 13 verbunden sind.

Bei dem Batteriesystem 1 wird jeweils über einen Analog-Digital-Konverter 8 die Batteriezellspannung einer Batteriezelle 2 von einem Mikrocontroller 9 als Batteriesystemparameter erfasst. Ein Mikrocontroller 9 des Batteriesystems 1 ist dabei jeweils über eine Isolatoreinheit 10 mit den Datenleitungen 3, 4, 7, 13 zum Senden und Empfangen von Daten verbunden.

Ein Mikrocontroller 9 des in Fig. 1 ausschnittsweise dargestellten Batteriesystems 1 erzeugt zur Übertragung eines minimalen Wertes einer Batteriezellspannung und zur Übertragung eines maximalen Wertes einer Batteriezellspannung phasensynchron zu dem von der Steuergeräteeinheit 6 erzeugten Taktsignal ein erstes pulsweitenmoduliertes Signal und ein zweites pulsweitenmoduliertes Signal. Das erste Signal kann dabei entweder einen ersten Signalzustand (low) oder einen zweiten Signalzustand (high) annehmen. Das zweite Signal kann ebenfalls entweder einen ersten Signalzustand (low) oder einen zweiten Signalzustand (high) annehmen. Das erste Signal wird über den Open-Collector-Ausgang 3' eines ersten Isolators 11 auf die erste Datenleitung 3 gegeben. Das zweite Signal wird über den Open-Collector-Ausgang 4' eines zweiten Isolators 12 auf die zweite Datenleitung 4 gegeben. Vorteilhafterweise kann ein Mikrocontroller 9 des Batteriesystems 1 jeweils über die Eingänge 3" und 4" auf der ersten Datenleitung 3 und/oder auf der zweiten Datenleitung 4 übertragene Signale empfangen. Diese empfangenen Signale können vorteilhafterweise von dem jeweiligen Mikrocontroller 9 ausgewertet werden und insbesondere von diesem Mikrocontroller 9 zur Regelung des Batteriesystems 1 genutzt werden, insbesondere indem die dem jeweiligen Mikrocontroller 9 zugeordnete Batteriezelle 2 überbrückt oder dem Batteriesystem 1 zugeschaltet wird.

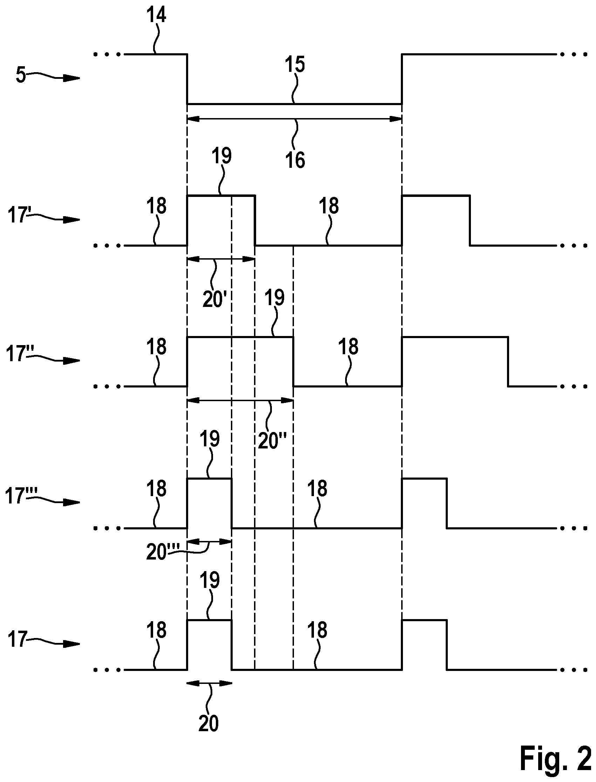

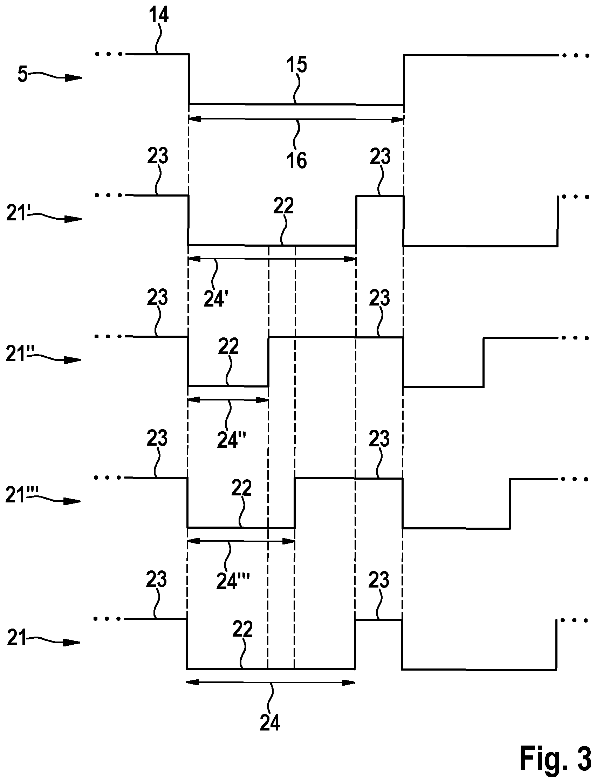

Die erfindungsgemäße Übertragung von minimalen Werten eines Batteriesystemparameters wird im Zusammenhang mit Fig. 2 näher erläutert. Die erfindungsgemäße Übertragung von maximalen Werten eines Batteriesystemparameters wird im Zusammenhang mit Fig. 3 näher erläutert. Dabei zeigt Fig. 2 ein vorgegebenes Taktsignal 5 mit einer festen Periodendauer 16. Das Taktsignal 5 ist dabei als Rechtecksignal ausgebildet und kann einen ersten Signalzustand 14 (high) oder einen zweiten Signalzustand 15 (low) annehmen. Phasensynchron zu dem Taktsignal 5 werden pulsweitenmodulierte Signale 17', 17", 17"', welche jeweils einen Wert eines Batteriesystemparameters repräsentieren, als erste Signale erzeugt. Das erste Signal 17' kann beispielsweise ein von dem in Fig. 1 dargestellten Mikrocontroller 9 des Batteriesystems 1 erzeugtes erstes Signal sein, welches den Wert einer an der Batteriezelle 2 abfallenden Batteriezellspannung repräsentiert. Die ersten Signale 17" und 17'" sind dabei die von weiteren, in Fig. 1 nicht dargestellten Mikrocontrollern des Batteriesystems 1 erzeugten ersten Signale, welche ihrerseits jeweils den Wert einer Batteriezellspannung als Batteriesystemparameter repräsentieren. Die ersten Signale 17', 17" und 17"' können, wie exemplarisch in Fig. 2 dargestellt, jeweils einen ersten Signalzustand 18 (low) oder einen zweiten Signalzustand 19 (high) annehmen. Ein minimaler Batteriesystemparameter wird dabei auf der ersten Datenleitung durch einen Übergang von dem ersten Signalzustand 18 zu dem zweiten Signalzustand 19 dargestellt. Der Wert des jeweiligen Batteriesystemparameters wird durch die zeitliche Dauer, die der zweite Signalzustand 19 gehalten wird, also durch die jeweilige Pulsdauer 20', 20", 20"', bezogen auf die Periodendauer 16 des Taktsignal 5 repräsentiert. In Fig. 2 repräsentiert das Signal 17" also den kleinsten Wert eines Batteriesystemparameters.

Die ersten Signale 17', 17" und 17'" werden durch eine UND-Verknüpfung logisch miteinander verknüpft, beispielsweise indem die Signale, wie in Fig. 1 für den gezeigten Ausschnitt des Batteriesystems 1 dargestellt, jeweils über einen entsprechenden Open-Collector-Ausgang 3' auf die erste Datenleitung 3 gegeben werden. Aus der Verundung der ersten Signale 17', 17" und 17'" resultiert das in Fig. 2 dargestellte Signal 17. Dieses entspricht dem Signal 17"', welches den minimalen Wert des erfassten Batteriesystemparameters entspricht. Das Signal 17 wird daher über die erste Datenleitung des Batteriesystems übertragen. Bezugnehmend auf Fig. 1 würde das Signal 17 also über die Datenleitung 3 übertragen, beispielsweise an die zentrale Steuergeräteeinheit 6 und/oder mittels entsprechender Anbindungen 3" über Isolatoreinheiten 10 an die Mikrocontroller 9 weiterer Batteriezellen 2 des Batteriesystems 1. Die Pulsweite 20 des Signals 17 stellt dabei den minimalen Wert aus den erfassten Batteriesystemparametern dar, wobei als Referenz die Periodendauer 16 des Taktsignals 5 dient.

Die Übertragung eines maximalen Wertes eines Batteriesystemparameters erfolgt in ähnlicher Weise, wie beispielhaft in Fig. 3 dargestellt. Phasensynchron zu einem zentralen Taktsignal 5 mit einer festen Periodendauer 16 wird ebenfalls für jeden Wert des Batteriesystemparameters ein zweites Signal 21', 21", 21'", welches entweder einen ersten Signalzustand 22 (low) oder einen zweiten Signalzustand 23 (high) annehmen kann, erzeugt und auf die zweite Datenleitung gegeben, bezugnehmend auf Fig. 1 also auf die Datenleitung 4. Ein maximaler Batteriesystemparameter wird dabei auf der zweiten Datenleitung durch einen Übergang von dem zweiten Signalzustand 23 (high) zu dem ersten Signalzustand 22 (low) dargestellt. Der Wert des jeweiligen Batteriesystemparameters wird dabei bei den Signalen 21', 21", 21"' durch die jeweilige zeitliche Dauer, die der erste Signalzustand 22 (low) gehalten wird, also die jeweilige Pulsweite 24', 24", 24"', bezogen auf Periodendauer 16 des Taktsignals 15 repräsentiert. Das Signal 21" repräsentiert dabei den maximalen Wert des Batteriesystemparameters. Da nur der maximale Wert des Batteriesystemparameters übertragen werden soll, wird das für einen Wert des Batteriesystemparameters auf die zweite Datenleitung gegebene zweite Signal, beispielsweise das Signal 21' auf der zweiten Datenleitung mittels zeitgleich auf die zweite Datenleitung gegebenen zweiten Signalen, also beispielsweise den Signalen 21" und 21'" der weiteren Werte des Batteriesystemparameters logisch verknüpft, vorliegend durch eine UND-Verknüpfung, sodass das resultierende Signal 21, welches den maximalen Wert des Batteriesystemparameters repräsentiert, über die zweite Datenleitung übertragen wird. Die Pulslänge 24 des Signals 21 repräsentiert dabei den maximalen Wert des jeweiligen Batteriesystemparameters, wobei als Referenz die Periodendauer 16 des Taktsignals 5 dient. Bezugnehmend auf Fig. 1 würde das Signal 21 über die Datenleitung 4 der zentralen Steuergeräteeinheit 6, sowie mittels entsprechender Anbindungen 4" über Isolatoreinheiten 10 den Mikrocontrollern 9 weiterer Batteriezellen 2 des Batteriesystems 1 zur Nutzung zur Verfügung stehen.

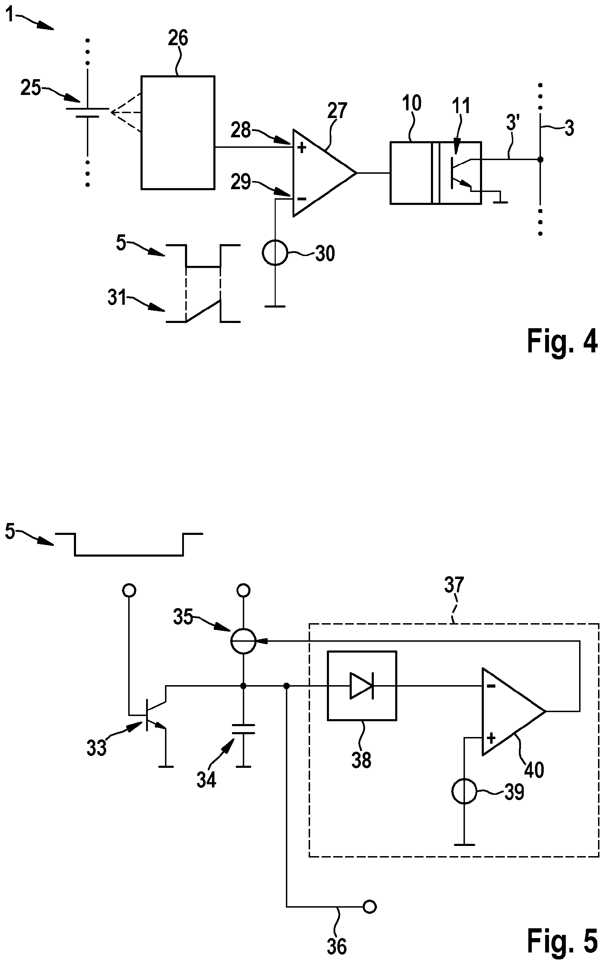

In Fig. 4 ist ein Ausschnitt eines weiteren Ausführungsbeispiels für ein Batteriesystem 1 gezeigt, welches zur Übertragung eines minimalen Wertes und eines maximalen Wertes eines Batteriesystemparameters aus einer Menge von Werten dieses Batteriesystemparameters ausgebildet ist. Das Batteriesystem 1 weist eine Mehrzahl von Batteriemodulen 25 auf (aus Gründen der besseren Übersichtlichkeit ist in Fig. 4 nur ein Batteriemodul 25 dargestellt). Ein Batteriemodul 25 umfasst dabei eine Mehrzahl von elektrisch miteinander verschalteten Batteriezellen, vorzugsweise von Lithium-Ionen-Zellen. Der in Fig. 4 gezeigte Ausschnitt wiederholt sich dabei für jedes Batteriemodul 25 des Batteriesystems 1 entsprechend. Unter Nutzung bekannter Messtechnik wird mittels einer einem Batteriemodul 25 jeweils zugeordneten Auswerteeinheit 26 die minimale und/oder maximale Batteriezellspannung der Batteriezellen eines jeden Batteriemoduls 25 des Batteriesystems 1 ermittelt.

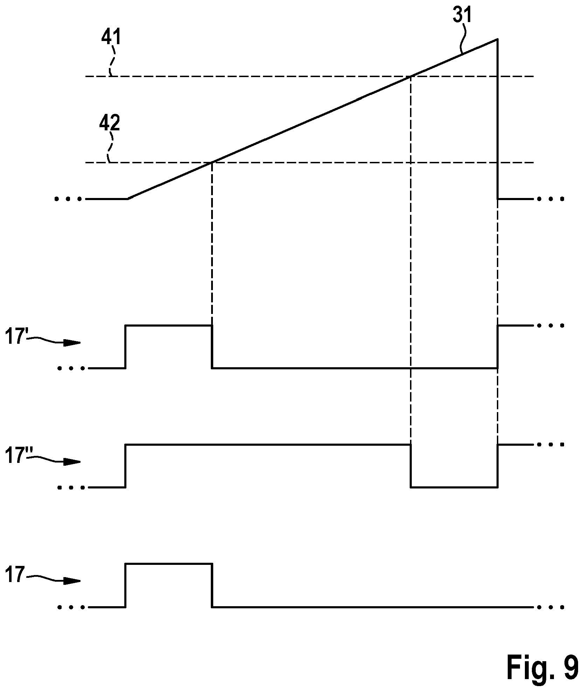

Bei dem in Fig. 4 ausschnittsweise dargestellten Batteriesystem 1 wird dabei phasensynchron zu einem zentralen Taktsignal 5 jeweils eine Sägezahnspannung 31 von einem Sägezahngenerator 30 erzeugt. Die von der Auswerteeinheit 26 erfasste minimale Spannung einer Batteriezelle des Batteriemoduls 25 wird dabei durch einen Vergleich der erfassten Spannung mit der Sägezahnspannung 31 unter Nutzung einer Komparatoreinheit 27 des Batteriesystems 1 verglichen. Die Komparatoreinheit 27 weist dabei einen positiven Eingang 28 und einen invertierenden Eingang 29 auf. Zur Erzeugung des ersten Signals, welches den Wert einer Batteriezellspannung repräsentiert, wird die von der Auswerteeinheit 26 erfasste minimale Spannung an den positiven Eingang 28 der Komparatoreinheit 27 angelegt. Die Sägezahnspannung 31 wird an den invertierenden Eingang 29 der Komparatoreinheit 27 angelegt. Über den Open-Collector-Ausgang 3' der Isolatoreinheit 10 wird das von der Komparatoreinheit 27 erzeugte Signal auf die erste Datenleitung 3 des Batteriesystems 1 gegeben. Da für weitere Batteriemodule 25 jeweils für minimale Spannungen eine Batteriezelle des jeweiligen Batteriemoduls 25 in gleicher Weise verfahren wird, erfolgt wiederum auf der ersten Datenleitung 3 des Batteriesystems 1 eine Verundung der erzeugten ersten Signale, wobei das Signal, welches den Wert der minimalen Spannung sämtlicher Batteriemodule 25 repräsentiert über die Datenleitung 3 übertragen wird, beispielsweise an eine zentrale Steuergeräteeinheit. Die Erzeugung eines ersten Signals unter Nutzung einer Sägezahnspannung und einer Komparatoreinheit wird im Zusammenhang mit Fig. 9 näher erläutert. Das Erzeugen der zu dem Taktsignal 5 phasensynchron Sägezahnspannung 31 erfolgt vorteilhafterweise wie im Zusammenhang mit Fig. 5 erläutert.

In Fig. 5 ist in einer vereinfachten schematischen Darstellung eine Schaltung dargestellt, mit welcher eine zu einem Taktsignal 5 synchrone Sägezahnspannung 31, welche über die Leitung 36 abgreifbar ist, erzeugt werden kann. Das Taktsignal 5 steuert dabei ein Schaltelement 33. Das Schaltelement 33 ist dabei vorzugsweise als MOSFET ausgebildet. Weist das Taktsignal 5 einen ersten Signalzustand auf, so schließt das Schaltelement 33. Bei einem zweiten Signalzustand des Taktsignals öffnet das Schaltelement 33. Ist das Schaltelement 33 geöffnet, so wird der Kondensator 34 von der Stromquelle 35 rampenförmig aufgeladen. Bei geschlossenem Schaltelement 33 wird der Kondensator 34 über das Schaltelement 33 wieder entladen. Damit die Rampensteilheit in allen Einheiten eines Batteriesystems, die eine Spannung als Batteriesystemparameter erfassen, gleich ist, wird der Strom der Stromquelle 35 mittels einer Regeleinrichtung 37 geregelt. Unter Nutzung einer Peak-Detektion-Einheit 38 und einer Operationsverstärkerschaltung 40 wird der den Kondensator 34 aufladende Strom derart geregelt, dass die Spannung des Kondensators 34 zum Zeitpunkt des Wechsels des Taktsignals 5 von dem ersten Signalzustand zu dem zweiten Signalzustand einer vorgegebenen Referenzspannung einer Referenzspannungsquelle 39 entspricht.

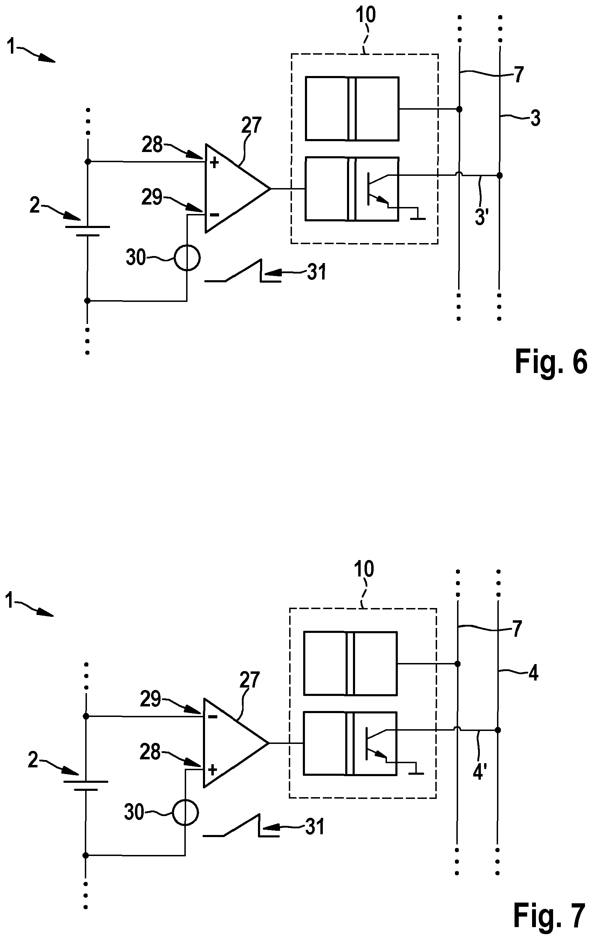

In Fig. 6 und Fig. 7 ist jeweils in einer schematischen Darstellung der Ausschnitt eines weiteren Ausführungsbeispiels für ein Batteriesystem 1 dargestellt. In Fig. 6 ist dabei schematisch dargestellt, wie die Übertragung eines minimalen Wertes einer Batteriezellspannung realisiert ist. Fig. 7 zeigt eine mögliche Realisierung zur Übertragung des maximalen Wertes einer Batteriezellspannung. Diese Realisierungen kommen dabei jeweils ohne einen Mikrocontroller aus, welcher aus einer Mehrzahl von Batteriezellspannungen eine minimale beziehungsweise maximale Batteriezellspannung erfasst. Besonders bevorzugt weist ein Batteriesystem 1 eine Kombination des in Fig. 6 und Fig. 7 dargestellten Prinzips auf, das heißt das ein solches Batteriesystem zur Übertragung eines minimalen Wertes einer Batteriezellspannung, wie im Zusammenhang mit Fig. 6 erläutert, und zur Übertragung eines maximalen Wertes einer Batteriezellspannung, wie im Zusammenhang mit Fig. 7 erläutert, ausgebildet ist. Für jede Batteriezelle 2 eines Batteriesystem 1 ist dabei eine entsprechende gleichartige Realisierung zur Erzeugung eines Signals, welches auf die Datenleitung 3 (Fig. 6) beziehungsweise auf die Datenleitung 4 (,Fig. 7) gegeben wird, vorgesehen.

Sowohl bei dem in Fig. 6 als auch bei dem in Fig. 7 dargestellten Ausführungsbeispiel wird über eine Leitung 7 jeweils ein zentrales Taktsignal mit fester Periodendauer vorgegeben, insbesondere ein Taktsignal wie im Zusammenhang mit Fig. 2 und Fig. 3 erläutert. Phasensynchron zu dem Taktsignal wird dabei jeweils eine Sägezahnspannung 31 von einem Sägezahngenerator 30 erzeugt (vorzugsweise wie im Zusammenhang mit Fig. 5 erläutert).

Bei dem in Fig. 6 dargestellten Ausführungsbeispiel wird die Sägezahnspannung 31 auf den invertierenden Eingang 29 einer Komparatoreinheit 27 gegeben. Eine an einer Batteriezelle 2 anliegende Batteriezellspannung wird auf den nicht invertierenden Eingang 28 der Komparatoreinheit 27 gegeben. Die Erzeugung des ersten Signals unter Nutzung der Komparatoreinheit 27 wird dabei im Zusammenhang mit Fig. 9 näher erläutert. Über eine Isolatoreinheit 10 wird das von der Komparatoreinheit 27 erzeugte Signal, welches beispielsweise die Form des in Fig. 2 dargestellten Signals 17 haben kann, auf die erste Datenleitung 3 gegeben. Da für jede Batteriezelle 2 des Batteriesystems 1 ein solches ersten Signal erzeugt wird, erfolgt durch die vorgesehene Verschaltung eine UND-Verknüpfung dieser ersten Signale auf der ersten Datenleitung 3, sodass über die erste Datenleitung 3 der minimale Wert einer Batteriezellspannung übertragen wird, beispielsweise an eine zentrale Steuergeräteeinheit.

Bei dem in Fig. 7 dargestellten Ausführungsbeispiel ist die Beschaltung der Komparatoreinheit 27 umgekehrt, da zur Übertragung des maximalen Wertes einer Batteriezellspannung auf der zweiten Datenleitung 4 vorgesehen ist, dass eine maximale Batteriezellspannung auf der zweiten Datenleitung 4 durch einen Übergang von dem zweiten Signalzustand (high) zu dem ersten Signalzustand (low) dargestellt wird. Bei dem in Fig. 7 dargestellten Ausführungsbeispiel wird daher eine zu dem Taktsignal phasensynchrone Sägezahnspannung 31 auf den positiven Eingang 28 der Komparatoreinheit 27 gegeben und eine an einer Batteriezelle 2 anliegende Batteriezellspannung auf den invertierenden Eingang 29 der Komparatoreinheit 27 gelegt. Über eine Isolatoreinheit 10 wird das Ausgangssignal der Komparatoreinheit 27 auf die zweite Datenleitung 4 gegeben. Da für jede Batteriezelle 2 des Batteriesystems 1 in entsprechender Weise ein zweites Signal erzeugt wird, erfolgt, wie beispielsweise in Zusammenhang mit Fig. 3 erläutert, eine UND-Verknüpfung der erzeugten zweiten Signale, sodass der maximale Wert einer Batteriezellspannung auf der zweiten Datenleitung 4 als pulsweitenmoduliertes Signal übertragen wird. Das auf der Datenleitung 4 übertragene zweite Signal kann beispielsweise wie das in Fig. 3 dargestellte Signal 21 ausgebildet sein. Das Verhältnis der Pulsweite des zweiten Signals zu der Periodendauer des Taktsignals 5 ergibt dabei vorteilhafterweise den maximalen Wert der Batteriezellspannung.

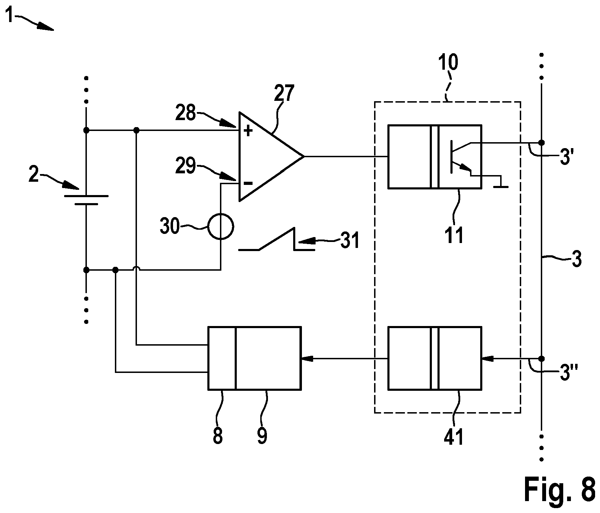

Fig. 8 zeigt beispielhaft eine Weiterentwicklung des in Fig. 6 ausschnittsweise dargestellten Batteriesystems 1. Vorteilhafterweise ist bei dem in Fig. 8 dargestellten Ausführungsbeispiel eines erfindungsgemäßen Batteriesystems 1 jeder Batteriezelle 2 ein Analog-Digital-Konverter 8 und ein Mikrocontroller 9 zugeordnet, wobei vorteilhafterweise über die erste Datenleitung 3 übertragene Signale über eine Isolatoreinheit 41 dem Mikrocontroller 9 als Eingangssignale zugeführt werden. Vorteilhafterweise nutzt der jeweiligen Mikrocontroller 9 diese Eingangssignale zur Realisierung weiterer Funktionen eines Batteriemanagementsystems. Insbesondere ist vorgesehen, dass die Mikrocontrollerschaltungen 9 unter Nutzung der Eingangssignale, also insbesondere der übertragenen minimalen und/oder maximalen Batteriezellspannungen, ausgebildet sind, ein Cell-Balancing durchzuführen und/oder einzelne Batteriezellen 2 dem Batteriesystem zuzuschalten und/oder einzelne Batteriezellen 2 durch Überbrücken von dem Batteriesystem 1 zu trennen.

Anhand von Fig. 9 wird beispielhaft die Erzeugung eines ersten Signals 17 unter Nutzung einer Sägezahnspannung 31 und einer Komparatoreinheit 27, wie im Zusammenhang mit Fig. 4, Fig. 6 und Fig. 8 dargestellt, erläutert. Die Menge der verglichenen Batteriezellspannung beträgt in dem in Fig. 9 gezeigten Beispiel zwei; es wird eine Batteriezellspannung 41 und eine Batteriezellspannung 42 erfasst. Wie im Zusammenhang mit Fig. 6 erläutert, wird dabei die Batteriezellspannung 41 mit einer zu einem Taktsignal phasensynchronen Sägezahnspannung 31 unter Nutzung einer Komparatoreinheit verglichen. Zeitgleich wird über eine weitere Komparatoreinheit eine Batteriezellspannung 42 mit einer zu dem Taktsignal phasensynchronen Sägezahnspannung 31 verglichen. Dabei wird die Batteriezellspannung 41 sowie die Batteriezellspannung 42 jeweils an den nicht invertierenden Eingang der Komparatoreinheit angelegt. Die Sägezahnspannung wird jeweils an den invertierenden Eingang der jeweiligen Komparatoreinheit angelegt. Die von den Komparatoreinheiten erzeugten ersten Signale 17' und 17" werden dabei auf eine erste Datenleitung gegeben. Das Signal 17' entsteht dabei durch Vergleich der Batteriezellspannung 42 mit der Sägezahnspannung 31 und das Signal 17" durch Vergleich der Batteriezellspannung 41 mit der Sägezahnspannung 31 als Ausgangssignal der jeweiligen Komparatoreinheit. Die ersten Signale 17' und 17" werden dabei durch die entsprechende Verschaltung, wie beispielsweise im Zusammenhang mit Fig. 6 erläutert, logisch UND-verknüpft, sodass das aus der UND-Verknüpfung resultierende Signal 17 über die Datenleitung 3 übertragen wird. Bei dem in Fig. 9 dargestellten Signal 17 kennzeichnet der Übergang des Signalzustandes von "low" zu "high" eine minimale Batteriezellspannung. Die Pulsweite des Signals, also die Zeitdauer, die der der "high"-Zustand des Signals 17 gehalten wird, in Bezug auf die Periodendauer des Taktsignals repräsentiert dabei den Wert der minimalen Batteriezellspannung.

Das über eine zweite Datenleitung 4 übertragene Signal, welches den maximalen Wert einer Batteriezellspannung repräsentiert, wird auf entsprechende Weise als Ausgangssignal einer Komparatoreinheit 27 erzeugt, wobei die Sägezahnspannung auf den nichtinvertierenden Eingang 28 und eine erfasste Batteriezellspannung auf den invertierenden Eingang 29 der Komparatoreinheit 27 gegeben wird.

Die in den Figuren dargestellten und im Zusammenhang mit diesen erläuterten Ausführungsbeispiele dienen der Erläuterung der Erfindung und sind für diese nicht beschränkend.

## Patentansprüche

1. Verfahren zum Übertragen eines minimalen und/oder eines maximalen Wertes eines Batteriesystemparameters aus einer Menge von Werten dieses Batteriesystemparameters in einem eine Mehrzahl von Batteriezellen (2) umfassenden Batteriesystem (1), wobei der minimale Wert des Batteriesystemparameters über eine erste Datenleitung (3) übertragen wird und/oder der maximale Wert des Batteriesystemparameters über eine zweite Datenleitung (4) übertragen wird, **dadurch gekennzeichnet, dass** ein periodisches Taktsignal (5) mit einer festen Periodendauer (16) erzeugt wird sowie zur Übertragung des minimalen Wertes des Batteriesystemparameters für jeden Wert des Batteriesystemparameters phasensynchron zu dem Taktsignal (5) ein erstes Signal (17', 17", 17"'), welches entweder einen ersten Signalzustand (18) oder einen zweiten Signalzustand (19) annehmen kann, erzeugt und auf die erste Datenleitung (3) gegeben wird, wobei ein minimaler Batteriesystemparameter auf der ersten Datenleitung (3) durch einen Übergang von dem ersten Signalzustand (18) zu dem zweiten Signalzustand (19) dargestellt wird und der minimale Wert des Batteriesystemparameters durch die zeitliche Dauer (20), die der zweite Signalzustand (19) gehalten wird, bezogen auf die Periodendauer (16) des Taktsignals (5) repräsentiert wird, und/oder zur Übertragung des maximalen Wertes des Batteriesystemparameters für jeden Wert des Batteriesystemparameters phasensynchron zu dem Taktsignal (5) ein zweites Signal (21', 21", 21"'), welches entweder einen ersten Signalzustand (22) oder einen zweiten Signalzustand (23) annehmen kann, erzeugt und auf die zweite Datenleitung (4) gegeben wird, wobei ein maximaler Batteriesystemparameter auf der zweiten Datenleitung (4) durch einen Übergang von dem zweiten Signalzustand (23) zu dem ersten Signalzustand (22) dargestellt wird und der maximale Wert des Batteriesystemparameters durch die zeitliche Dauer (24), die der erste Signalzustand (22) gehalten wird, bezogen auf die Periodendauer (16) des Taktsignals (5) repräsentiert wird.

2. Verfahren nach Anspruch 1, **dadurch gekennzeichnet, dass** das für einen Wert des Batteriesystemparameters auf die erste Datenleitung (3) gegebene erste Signal (17') auf der ersten Datenleitung (3) mit den zeitgleich auf die erste Datenleitung (3) gegebenen ersten Signalen (17", 17"') der weiteren Werte des Batteriesystemparameters logisch verknüpft wird, sodass der minimale Wert des Batteriesystemparameters über die erste Datenleitung (3) übertragen wird, und/oder dass das für einen Wert des Batteriesystemparameters auf die zweite Datenleitung (4) gegebene zweite Signal (21') auf der zweiten Datenleitung (4) mit den zeitgleich auf die zweite Datenleitung (4) gegebenen zweiten Signalen (21", 21'") der weiteren Werte des Batteriesystemparameters logisch verknüpft wird, sodass der maximale Wert des Batteriesystemparameters über die zweite Datenleitung (4) übertragen wird.

3. Verfahren nach einem der vorhergehenden Ansprüche, **dadurch gekennzeichnet, dass** als Menge von Werten des Batteriesystemparameters jeweils die minimale Spannung und/oder die maximale Spannung einer Batteriezelle (2) eines Batteriemoduls (25) des Batteriesystems (1) erfasst wird und der minimale Wert der erfassten minimalen Spannung und/oder der maximale Wert der erfassten maximalen Spannung übertragen wird, wobei für jedes Batteriemodul (25) zur Übertragung des minimalen Wertes der erfassten minimalen Spannung jeweils phasensynchron zu dem Taktsignal (5) das erste Signal (17', 17", 17"') erzeugt und auf die erste Datenleitung (3) gegeben wird und/oder für jedes Batteriemodul (25) zur Übertragung des maximalen Wertes der erfassten maximalen Spannung jeweils phasensynchron zu dem Taktsignal (5) das zweite Signal (21', 21", 21'") erzeugt und auf die zweite Datenleitung (4) gegeben wird.

4. Verfahren nach Anspruch 1 oder Anspruch 2, **dadurch gekennzeichnet, dass** als Menge von Werten des Batteriesystemparameters jeweils die Batteriezellspannung einer Batteriezelle (2) des Batteriesystems (1) erfasst wird und der minimale Wert der erfassten Batteriezellspannung und/oder der maximale Wert der erfassten Batteriezellspannung übertragen wird, wobei für jede Batteriezelle (2) zur Übertragung des minimalen Wertes der erfassten Batteriezellspannung jeweils phasensynchron zu dem Taktsignal (5) das erste Signal (17', 17", 17"') erzeugt und auf die erste Datenleitung (3) gegeben wird und/oder für jede Batteriezelle (2) zur Übertragung des maximalen Wertes der erfassten Batteriezellspannung jeweils phasensynchron zu dem Taktsignal (5) das zweite Signal (21', 21", 21'") erzeugt und auf die zweite Datenleitung (4) gegeben wird.

5. Verfahren nach einem der Ansprüche 2 bis 4, **dadurch gekennzeichnet, dass** phasensynchron zu dem Taktsignal (5) eine Sägezahnspannung (31) erzeugt wird, wobei eine Spannung, deren minimaler und/oder maximaler Wert übertragen werden soll, erfasst wird und durch jeweils einen Vergleich der erfassten Spannung (41, 42) mit der Sägezahnspannung (31) unter Nutzung einer Komparatoreinheit (27) mit einem positiven Eingang (28) und einem invertierenden Eingang (29) das erste Signal (17', 17", 17"') und/oder das zweite Signal (21', 21", 21'") als Ausgangssignal der Komparatoreinheit (27) erzeugt wird.

6. Verfahren nach Anspruch 5, **dadurch gekennzeichnet, dass** zur Erzeugung des ersten Signals (17', 17") die erfasste Spannung (41, 42) jeweils an den positiven Eingang (28) der Komparatoreinheit (27) angelegt wird und die Sägezahnspannung (31) jeweils an den invertierenden Eingang (29) der Komparatoreinheit (27) angelegt wird und/oder dass zur Erzeugung des zweiten Signals (21', 21", 21'") die erfasste Spannung jeweils an den invertierenden Eingang (29) der Komparatoreinheit (27) angelegt wird und die Sägezahnspannung (31) jeweils an den positiven Eingang (28) der Komparatoreinheit (27) angelegt wird.

7. Verfahren nach einem der vorhergehenden Ansprüche, **dadurch gekennzeichnet, dass** das erste Signal (17', 17", 17"') über eine galvanische Trenneinrichtung (11) auf die erste Datenleitung (3) gegeben wird und/oder das zweite Signal (21', 21", 21'") über eine galvanische Trenneinrichtung (12) auf die zweite Datenleitung (4) gegeben wird.

8. Verfahren nach einem der Ansprüche 5 bis 7, **dadurch gekennzeichnet, dass** zur Erzeugung der Sägezahnspannung (31) das Taktsignal (5) für jede zu erzeugende Sägezahnspannung (31) jeweils ein Schaltelement (33) steuert, wobei das Schaltelement (33) bei einem ersten Signalzustand (14) des Taktsignals (5) schließt und bei einem zweiten Signalzustand (15) des Taktsignals (5) öffnet, wobei bei geöffnetem Schaltelement (33) ein Kondensator (34) rampenförmig aufgeladen wird und bei geschlossenem Schaltelement (33) der Kondensator (34) entladen wird.

9. Verfahren nach Anspruch 8, **dadurch gekennzeichnet, dass** der den Kondensator (34) aufladende Strom derart geregelt wird, dass die Spannung des Kondensators (34) zum Zeitpunkt des Wechsels des Taktsignals (5) von dem ersten Signalzustand (14) zu dem zweiten Signalzustand (15) einer vorgegebenen Referenzspannung (39) entspricht.

10. Verfahren nach einem der vorhergehenden Ansprüche, **dadurch gekennzeichnet, dass** ein auf die erste Datenleitung (3) gegebenes erstes Signal (17', 17", 17"') und/oder ein auf die zweite Datenleitung (4) gegebenes zweites Signal (21', 21", 21'") von Einheiten (9) des Batteriesystems (1) empfangen und ausgewertet werden.

11. Batteriesystem (1) mit einer Mehrzahl von Batteriezellen (2) und einem Batteriemanagementsystem, **dadurch gekennzeichnet, dass** das Batteriesystem (1) zur Ausführung eines Verfahrens nach einem der Ansprüche 1 bis 10 ausgebildet ist.

## Claims

1. Method for transferring a minimum and/or a maximum value of a battery system parameter from a set of values for this battery system parameter in a battery system (1) comprising a plurality of battery cells (2), the minimum value of the battery system parameter being transferred via a first data line (3) and/or the maximum value of the battery system parameter being transferred via a second data line (4), **characterized in that** a periodic clock signal (5) having a fixed period duration (16) is generated and, in order to transfer the minimum value of the battery system parameter, a first signal (17', 17", 17"') which can assume either a first signal state (18) or a second signal state (19) is generated for each value of the battery system parameter synchronously in phase with the clock signal (5) and is passed to the first data line (3), a minimum battery system parameter on the first data line (3) being represented by a transition from the first signal state (18) to the second signal state (19), and the minimum value of the battery system parameter being represented by the duration (20) of time for which the second signal state (19) is held based on the period duration (16) of the clock signal (5), and/or, in order to transfer the maximum value of the battery system parameter, a second signal (21', 21", 21"') which can assume either a first signal state (22) or a second signal state (23) is generated for each value of the battery system parameter synchronously in phase with the clock signal (5) and is passed to the second data line (4), a maximum battery system parameter on the second data line (4) being represented by a transition from the second signal state (23) to the first signal state (22), and the maximum value of the battery system parameter being represented by the duration (24) of time for which the first signal state (22) is held based on the period duration (16) of the clock signal (5).

2. Method according to Claim 1, **characterized in that** the first signal (17') on the first data line (3) which was passed to the first data line (3) for a value of the battery system parameter is logically linked to the first signals (17", 17"') passed to the first data line (3) at the same time for the further values of the battery system parameter, with the result that the minimum value of the battery system parameter is transferred via the first data line (3), and/or **in that** the second signal (21') on the second data line (4) which was passed to the second data line (4) for a value of the battery system parameter is logically linked to the second signals (21", 21"') passed to the second data line (4) at the same time for the further values of the battery system parameter, with the result that the maximum value of the battery system parameter is transferred via the second data line (4).

3. Method according to one of the preceding claims, **characterized in that**, as the set of values for the battery system parameter, the minimum voltage and/or the maximum voltage of a battery cell (2) of a battery module (25) of the battery system (1) is/are respectively recorded and the minimum value of the recorded minimum voltage and/or the maximum value of the recorded maximum voltage is/are transferred, the first signal (17', 17", 17"') being generated for each battery module (25) for the purpose of transferring the minimum value of the recorded minimum voltage synchronously in phase with the clock signal (5) in each case and being passed to the first data line (3), and/or the second signal (21', 21", 21"') being generated for each battery module (25) for the purpose of transferring the maximum value of the recorded maximum voltage synchronously in phase with the clock signal (5) in each case and being passed to the second data line (4).

4. Method according to Claim 1 or Claim 2, **characterized in that**, as the set of values for the battery system parameter, the battery cell voltage of a battery cell (2) of the battery system (1) is recorded in each case and the minimum value of the recorded battery cell voltage and/or the maximum value of the recorded battery cell voltage is/are transferred, the first signal (17', 17", 17"') being generated for each battery cell (2) for the purpose of transferring the minimum value of the recorded battery cell voltage synchronously in phase with the clock signal (5) in each case and being passed to the first data line (3), and/or the second signal (21', 21", 21"') being generated for each battery cell (2) for the purpose of transferring the maximum value of the recorded battery cell voltage synchronously in phase with the clock signal (5) in each case and being passed to the second data line (4).

5. Method according to one of Claims 2 to 4, **characterized in that** a sawtooth voltage (31) is generated synchronously in phase with the clock signal (5), a voltage whose minimum and/or maximum value is intended to be transferred being recorded and the first signal (17', 17", 17"') and/or the second signal (21', 21", 21"') being generated, by respectively comparing the recorded voltage (41, 42) with the sawtooth voltage (31) using a comparator unit (27) having a positive input (28) and an inverting input (29), as the output signal from the comparator unit (27).

6. Method according to Claim 5, **characterized in that**, in order to generate the first signal (17', 17"), the recorded voltage (41, 42) is respectively applied to the positive input (28) of the comparator unit (27) and the sawtooth voltage (31) is respectively applied to the inverting input (29) of the comparator unit (27), and/or **in that**, in order to generate the second signal (21', 21", 21"'), the recorded voltage is respectively applied to the inverting input (29) of the comparator unit (27) and the sawtooth voltage (31) is respectively applied to the positive input (28) of the comparator unit (27).

7. Method according to one of the preceding claims, **characterized in that** the first signal (17', 17", 17"') is passed to the first data line (3) via a DC isolation device (11) and/or the second signal (21', 21", 21''') is passed to the second data line (4) via a DC isolation device (12).

8. Method according to one of Claims 5 to 7, **characterized in that**, in order to generate the sawtooth voltage (31), the clock signal (5) for each sawtooth voltage (31) to be generated respectively controls a switching element (33), the switching element (33) closing during a first signal state (14) of the clock signal (5) and opening during a second signal state (15) of the clock signal (5), a capacitor (34) being charged in a ramped manner when the switching element (33) is open and the capacitor (34) being discharged when the switching element (33) is closed.

9. Method according to Claim 8, **characterized in that** the current charging the capacitor (34) is regulated in such a manner that the voltage of the capacitor (34) corresponds to a predefined reference voltage (39) at the time at which the clock signal (5) changes from the first signal state (14) to the second signal state (15).

10. Method according to one of the preceding claims, **characterized in that** a first signal (17', 17", 17"') passed to the first data line (3) and/or a second signal (21', 21", 21"') passed to the second data line (4) is/are received and evaluated by units (9) of the battery system (1).

11. Battery system (1) having a plurality of battery cells (2) and a battery management system, **characterized in that** the battery system (1) is designed to carry out a method according to one of Claims 1 to 10.

## Revendications

1. Procédé de transmission d'une valeur minimale et/ou maximale d'un paramètre de système de batteries issues d'un certain nombre de valeurs de ce paramètre de système de batteries dans un système de batteries (1) comprenant une pluralité de cellules de batterie (2), la valeur minimale du paramètre de système de batteries étant transmise par une première ligne de données (3) et/ou la valeur maximale du paramètre de système de batteries étant transmise par une deuxième ligne de données (4), **caractérisé en ce qu'**un signal d'horloge (5) périodique ayant une première durée de période (16) fixe est généré et, en vue de transmettre la valeur minimale du paramètre de système de batteries, un premier signal (17', 17", 17"') est généré pour chaque valeur du paramètre de système de batteries en synchronisation de phase avec le signal d'horloge (5), lequel peut adopter soit un premier état de signal (18), soit un deuxième état de signal (19), puis est délivré sur la première ligne de données (3), un paramètre de système de batteries minimal étant représenté sur la première ligne de données (3) par une transition du premier état de signal (18) vers le deuxième état de signal (19) et la valeur minimale du paramètre de système de batteries étant représentée par la durée (20) dans le temps pendant laquelle est maintenu le deuxième état de signal (19), par rapport à la durée de période (16) du signal d'horloge (5), et/ou en vue de transmettre la valeur maximale du paramètre de système de batteries, un deuxième signal (21', 21", 21"') est généré pour chaque valeur du paramètre de système de batteries en synchronisation de phase avec le signal d'horloge (5), lequel peut adopter soit un premier état de signal (22), soit un deuxième état de signal (23), puis est délivré sur la deuxième ligne de données (4), un paramètre de système de batteries maximal étant représenté sur la deuxième ligne de données (4) par une transition du deuxième état de signal (23) vers le premier état de signal (22) et la valeur maximale du paramètre de système de batteries étant représentée par la durée (24) dans le temps pendant laquelle est maintenu le premier état de signal (22), par rapport à la durée de période (16) du signal d'horloge (5) .

2. Procédé selon la revendication 1, **caractérisé en ce que** le premier signal (17') délivré sur la première ligne de données (3) pour une valeur du paramètre de système de batteries est lié logiquement avec les premiers signaux (17", 17"') des autres valeurs du paramètre de système de batteries délivrés simultanément sur la première ligne de données (3), de sorte que la valeur minimale du paramètre de système de batteries est transmise par le biais de la première ligne de données (3), et/ou **en ce que** le deuxième signal (21') délivré sur la deuxième ligne de données (4) pour une valeur du paramètre de système de batteries est lié logiquement sur la deuxième ligne de données (4) avec les deuxièmes signaux (21", 21"') des autres valeurs du paramètre de système de batteries délivrés simultanément sur la deuxième ligne de données (4), de sorte que la valeur maximale du paramètre de système de batteries est transmise par le biais de la deuxième ligne de données (4) .

3. Procédé selon l'une des revendications précédentes, **caractérisé en ce que** le certain nombre de valeurs du paramètre de système de batteries acquises sont à chaque fois la tension minimale et/ou la tension maximale d'une cellule de batterie (2) d'un module de batterie (25) du système de batterie (1) et la valeur minimale de la tension minimale acquise et/ou la valeur maximale de la tension maximale acquise sont transmises, pour chaque module de batterie (25), en vue de transmettre la valeur minimale de la tension minimale acquise, le premier signal (17', 17", 17"') étant respectivement généré en synchronisation de phase avec le signal d'horloge (5) et délivré sur la première ligne de données (3) et/ou pour chaque module de batterie (25), en vue de transmettre la valeur maximale de la tension maximale acquise, le deuxième signal (21', 21", 21"') étant respectivement généré en synchronisation de phase avec le signal d'horloge (5) et délivré sur la deuxième ligne de données (4).

4. Procédé selon la revendication 1 ou la revendication 2, **caractérisé en ce que** le certain nombre de valeurs du paramètre de système de batteries acquises sont à chaque fois la tension de cellule de batterie d'une cellule de batterie (2) du système de batterie (1) et la valeur minimale de la tension de cellule de batterie acquise et/ou la valeur maximale de la tension de cellule de batterie acquise sont transmises, pour chaque cellule de batterie (2), en vue de transmettre la valeur minimale de la tension de cellule de batterie acquise, le premier signal (17', 17", 17"') étant respectivement généré en synchronisation de phase avec le signal d'horloge (5) et délivré sur la première ligne de données (3) et/ou pour chaque cellule de batterie (2), en vue de transmettre la valeur maximale de la tension de cellule de batterie acquise, le deuxième signal (21', 21", 21"') étant respectivement généré en synchronisation de phase avec le signal d'horloge (5) et délivré sur la deuxième ligne de données (4).

5. Procédé selon l'une des revendications 2 à 4, **caractérisé en ce qu'**une tension en dents de scie (31) est générée en synchronisation de phase avec le signal d'horloge (5), une tension dont la valeur minimale et/ou maximale doit être transmise étant acquise et le premier signal (17', 17", 17"') et/ou le deuxième signal (21', 21", 21"') étant générés en tant que signal de sortie d'une unité de comparateur (27), pourvue d'une entrée positive (28) et d'une entrée inverseuse (29), respectivement par une comparaison de la tension (41, 42) acquise avec la tension en dents de scie (31) en utilisant une unité de comparateur (27).

6. Procédé selon la revendication 5, **caractérisé en ce que** pour générer le premier signal (17', 17"), la tension (41, 42) acquise est à chaque fois appliquée à l'entrée positive (28) de l'unité de comparateur (27) et la tension en dents de scie (31) est à chaque fois appliquée à l'entrée inverseuse (29) de l'unité de comparateur (27) et/ou **en ce que** pour générer le deuxième signal (21', 21", 21"'), la tension acquise est respectivement appliquée à l'entrée inverseuse (29) de l'unité de comparateur (27) et la tension en dents de scie (31) est à chaque fois appliquée à l'entrée positive (28) de l'unité de comparateur (27).

7. Procédé selon l'une des revendications précédentes, **caractérisé en ce que** le premier signal (17', 17", 17"') est délivré sur la première ligne de données (3) par le biais d'un dispositif d'isolation galvanique (11) et/ou le deuxième signal (21', 21", 21"') est délivré sur la deuxième ligne de données (4) par le biais d'un dispositif d'isolation galvanique (12).

8. Procédé selon l'une des revendications 5 à 7, **caractérisé en ce que** pour générer la tension en dents de scie (31), le signal d'horloge (5) commande à chaque fois un élément de commutation (33) pour chaque tension en dents de scie (31) à générer, l'élément de commutation (33) se fermant en présence d'un premier état de signal (14) du signal d'horloge (5) et s'ouvrant en présence d'un deuxième état de signal (15) du signal d'horloge (5), un condensateur (34) étant chargé en forme de rampe lorsque l'élément de commutation (33) est ouvert et le condensateur (34) étant déchargé lorsque l'élément de commutation (33) est fermé.

9. Procédé selon la revendication 8, **caractérisé en ce que** le courant qui charge le condensateur (34) est régulé de telle sorte que la tension du condensateur (34) corresponde à une tension de référence (39) prédéfinie au moment du basculement du signal d'horloge (5) du premier état de signal (14) au deuxième état de signal (15) .

10. Procédé selon l'une des revendications précédentes, **caractérisé en ce qu'**un premier signal (17', 17", 17"') délivré sur la première ligne de données (3) et/ou un deuxième signal (21', 21", 21"') délivré sur la deuxième ligne de données (4) sont reçus et interprétés par des unités (9) du système de batteries (1) .

11. Système de batteries (1) comprenant une pluralité de cellules de batterie (2) et un système de gestion de batterie, **caractérisé en ce que** le système de batteries (1) est configuré pour mettre en oeuvre un procédé selon l'une des revendications 1 à 10.
